# EUROPEAN PATENT SPECIFICATION

(11) **EP 2 495 760 B1**
(45) Date of publication and mention of the grant of the patent: **27.11.2019**
(21) Application number: 12155167.5
(22) Date of filing: 13.02.2012
(51) Int. Cl.: H01L 23/427

(54) **Thermal spreader with phase change thermal capacitor for electrical cooling**
Wärmeverteiler mit Phasenwechsel-Wärmekondensator zur elektrischen Kühlung
Dissipateur thermique avec condensateur thermique de changement de phase pour refroidissement électrique

(30) Priority: 14.02.2011 US 201113026727
(43) Date of publication of application: 05.09.2012
(73) Proprietor: Hamilton Sundstrand Corporation, Windsor Locks, CT 06096-1010 (US)
(72) Inventor: Andres, Michael J., Roscoe, IL 61073 (US); Downing, Robert Scott, Rockford, IL 61107 (US)
(74) Representative: Dehns

(56) References cited:
- EP-A1- 1 416 534
- EP-A2- 1 162 659
- EP-A2- 2 154 938
- DE-A1- 19 932 441

## Description

### BACKGROUND

The present invention relates generally to electronics cooling, and more particularly to electronics cooling for high peak thermal output or loss of cooling conditions.

Electronic components typically function optimally at a range of temperatures. Above optimal temperatures, most electronics will degrade more rapidly, and may cease to function altogether. For this reason, electronic components in hot environments or which generate large amounts of heat are commonly cooled via dedicated cooling systems.

Some electronic components, such as motor drives, power conversion units, and electric actuators, often experience uneven duty cycles, wherein peak thermal loads are much higher than median or non-peak thermal loads. In the past, peak load conditions have been determinative in selecting cooling systems for such components. In order to ride through peak thermal load periods which may last on the order of a few minutes or seconds, components have conventionally been over-cooled during normal conditions, requiring larger and more costly cooling systems and/or utilizing a colder or more efficient coolant. This added bulk and weight is undesirable, particularly in aerospace applications where weight is a major concern. Additionally, fluctuations in component temperatures under conventional practices may decrease component operating life. Likewise, if an electronic component must tolerate a loss-of-coolant event, the component is conventionally over-cooled during normal operation, or additional components are added to divide functionality and reduce individual component losses and peak heat fluxes. EP 1 416 534 A1 and DE 199 32 441 A1 disclose means for cooling circuits.

### SUMMARY

The present invention is directed toward a cooling apparatus as recited in claim 1 for high peak load electronics, and an associated method as recited in claim 13. A thermal spreader is in thermal contact with an electronic component to be cooled, a thermal capacitor, and a cold plate. The cold plate dissipates heat, and the thermal capacitor stores heat in a phase transition during peak loads and reduced coolant events.

### BRIEF DESCRIPTION OF THE DRAWINGS

FIG. 1 is an isometric view of a cooling apparatus of the present invention.
FIG. 2 is an exploded view of the cooling apparatus of FIG. 1.
FIG. 3 is a cross sectional view of the cooling apparatus of FIG. 1.

### DETAILED DESCRIPTION

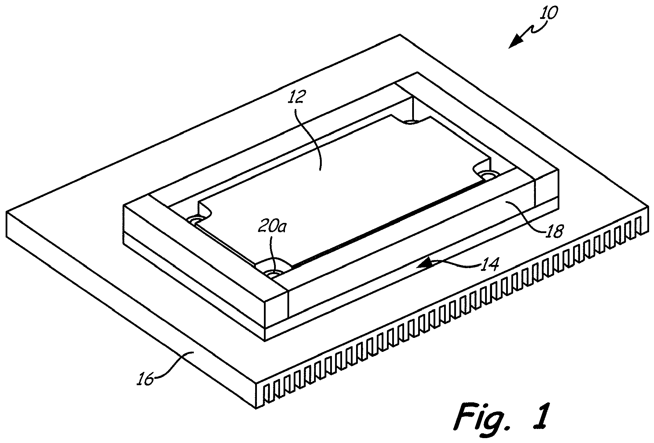

FIG. 1 shows cooling assembly 10 comprising electronic component 12, thermal spreader 14 (with bolt holes 20a), cold plate 16, and thermal capacitor 18. Electronic component 12 is a component which experiences peak thermal loads considerably higher than median or non-peak loads, as discussed above, and may for instance be a power conversion, motor drive, or electric actuator component. In some embodiments, electronic component 12 may be a circuit fabricated on a silicon die or a power switching device with multiple dies on a substrate and base plate. Electronic component 12 abuts and is in thermal contact with thermal spreader 14, which may be a heat pipe plate, a graphite plate, or any other thermal spreader capable of laterally spreading heat with a small temperature gradient across its entirety during operating conditions of cooling assembly 10. To maximize thermal conductivity between electronic component 12 and thermal spreader 14, electronic component 12 and thermal spreader 14 may be in thermal contact over substantially the entire length of either component.

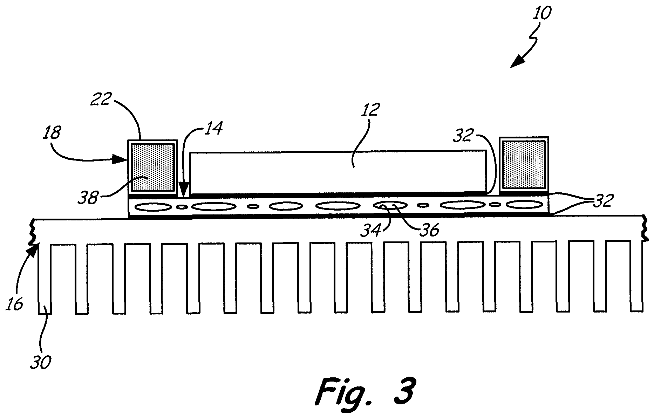

Thermal spreader 14 is also in thermal contact with cold plate 16 and thermal capacitor 18. Cold plate 16 may be a conventional heat exchanger, which may dissipate heat into a fluid such as air or a liquid coolant. Thermal capacitor 18 is a phase change thermal capacitor capable of storing large amounts of heat during a phase transition (i.e. melting) of a phase change material, as will be described in greater detail with respect to FIG. 3.

During steady state non-peak loads of electronic component 12, heat generated by electronic component 12 will be transmitted through thermal spreader 14 to cold plate 16. Cold plate 16 dissipates heat into the fluid coolant, which carries heat away from cooling assembly 10. During non-peak loads of electronic component 12, therefore, cooling assembly 10 will operate at roughly a steady state temperature. Cold plate 16 is selected to provide sufficient cooling such that this steady state temperature is well below a critical temperature at which electronic component 12 begins to experience deleterious effects from heat. Thermal spreader 14 reduces the temperature of cooling assembly 10 during steady state operation by providing a larger footprint for cooling.

During peak loads of electronic component 12, cold plate 16 may not be capable of dissipating sufficient heat to protect electronic component 12. from excessive temperature excursions. As excess heat builds up, the temperature of cooling assembly 10 will rise until a transition temperature (i.e. melting point) of thermal capacitor 18 is reached. At this transition temperature, phase change material within thermal capacitor 18 (see FIG. 3) will continue to absorb heat with very little increase in temperature until either all of the phase change material melts, or the peak condition passes. Thermal spreader 14 ensures that all components of cooling assembly 10 are kept at an approximately uniform temperature. When the peak condition passes, heat stored in thermal capacitor 18 is dissipated by cold plate 16 until cooling assembly 10 returns to the aforementioned steady state temperature. If the phase change material completely melts during the peak load condition, the temperature of cooling assembly 10 will continue to increase, potentially damaging electronic component 12. Thermal capacitor 18 is therefore selected to provide sufficient heat storage to ride through any anticipated peak condition without completely melting. By providing adequate heat storage in the form of thermal capacitor 18, cooling assembly 10 can cool electronic component 12 adequately during both peak and non-peak conditions with limited bulk or weight.

In another scenario, loss of coolant fluid at cold plate 16 may impair the heat dissipation capacity of cooling assembly 10. Thermal capacitor 18 allows electronic component 12 to be kept at acceptable temperatures during such loss-of-coolant conditions until all phase change material melts, as described above, thereby allowing cooling assembly 10 to ride through transient loss-of-coolant conditions.

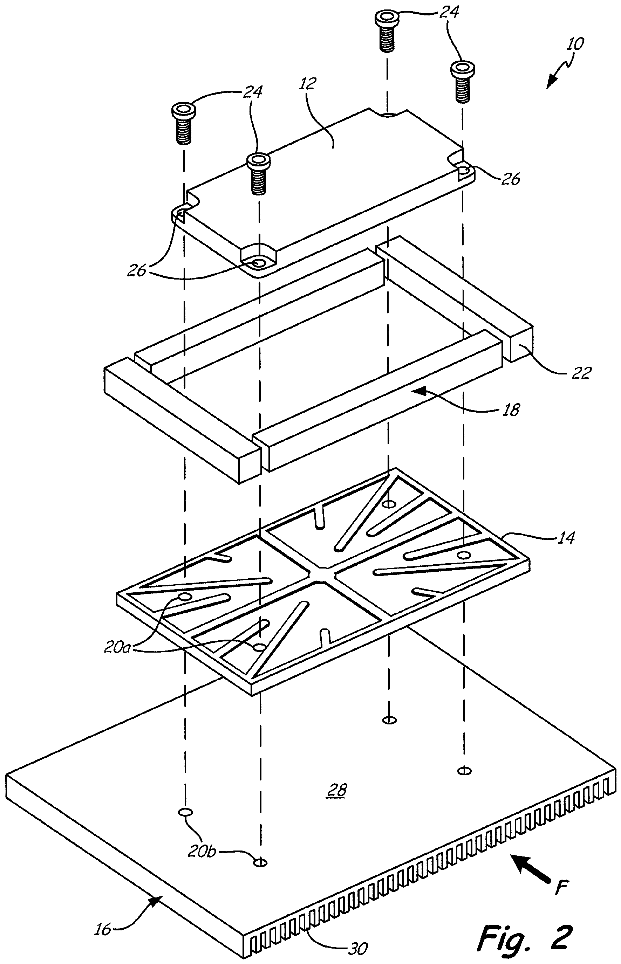

FIG. 2 is an exploded view of cooling assembly 10, comprising electronic component 12 (with bolt locations 26), thermal spreader 14 (with bolt holes 20a), cold plate 16 (with bolt holes 20b, flat surface 28, and fins 30), thermal capacitor 18 (with receptacle 22), and bolts 24. In the illustrated embodiment, electronic component 12, cold plate 16, and thermal capacitor 18 are substantially planar components, while thermal capacitor 18 is comprised of several box-like receptacles 22 which surround electronic component 12 atop thermal spreader 14. Receptacle 22 may be half-cylindrical in shape. Thermal capacitor 18 may be positioned in other locations in thermal contact with thermal spreader 14, or in direct thermal contact with cold plate 16, and may comprise only a single receptacle 22.

Electronic component 12, thermal spreader 14, cold plate 16, and thermal capacitor 18 are anchored together in an assembled configuration. In the illustrated embodiment, bolts 24 are inserted through bolt slots 26 in electronic component 12, bolt holes 20a in thermal spreader 14, and bolt holes 20b and cold plate 16, while thermal capacitor 18 is secured separately. As bolt 24 is tightened, thermal spreader 14 is anchored atop cold plate 16, and electronic component 12 is anchored atop thermal spreader 14. In alternative embodiments, some or all of the components of cooling assembly 10 may be held together by alternative means, such as by adhesives, soldering, welding or clamping. Bolt holes 20a passes through a boss in thermal spreader 18, so that the working fluid of thermal spreader 18 is not exposed to bolt 24 or to the environment.

Cold plate 16 abuts thermal spreader 14 at a flat surface 28, and may comprise a plurality of fins 30 for increased contact area with a cooling fluid flow F. As fluid flows between and around fins 30, cold plate 16 dissipates heat into the fluid, cooling the entirety of cooling assembly 10. Cold plate 16 is constructed of a thermally conductive material, such as aluminum. Thermal spreader 14 maximizes heat transfer between components, equalizing temperature across cooling assembly 10, and thereby assuring that electronic component 12 will remains relatively cool at all times.

FIG. 3 is a cross-sectional view of cooling assembly 10, comprising electronic component 12, thermal spreader 14 (with vapor space 34 carrying working fluid 36), cold plate 16 (with fins 30 and flat surface 28), thermal capacitor 18 (with receptacle 22 and phase change material 38), and thermal interface material 32.

As discussed previously, thermal spreader 14 is in thermal contact with electronic component 12, cold plate 16, and thermal capacitor 18 to equalize temperatures among these components. Thermal interface material 32 may be inserted at interfaces between thermal spreader 14 and electronic component 12, cold plate 16, and thermal capacitor 18, to improve thermal conductivity. Thermal interface material 32 may be, for instance, thermal grease or a thermally conductive pad.

In the pictured embodiment, thermal spreader 14 is a conventional heat pipe plate wherein wicked vapor space 34 carries working fluid 36. Heat applied to any region of thermal spreader 14 causes working fluid in that region to evaporate to vapor. This vapor migrates through vapor space 34 to cooler regions of thermal spreader 14, where it condenses and is absorbed by the wick, releasing heat. Liquid working fluid then flows by capillary forces to replenish fluid evaporated from the hot region. In this way, temperatures are efficiently equalized across thermal spreader 14. In one embodiment, thermal spreader 14 is formed of aluminum and working fluid 36 is methanol. In another embodiment, thermal spreader 14 is formed of copper and working fluid 36 is water. As mentioned with respect to FIG. 1, other thermal spreaders may be used. In one embodiment, for instance, a graphite plate may replace the depicted heat pipe plate.

Thermal capacitor 18 comprises at least one thermally conductive receptacle 22 filled with phase change material 38. Receptacle 22 may be constructed, for instance, of aluminum. Phase change material 38 is a material with a high heat of fusion, which melts and solidifies at a suitable transition temperature. Large amounts of energy can be stored in phase change material 38 at the transition temperature, allowing phase change material 38 it to serve as a heat storage device. Phase change material 38 may be, for example, a low temperature solder, salt, or paraffin-family wax, and is selected to have a transition temperature between the steady state temperature of cooling assembly 10 and the critical temperature of electronic component 12, as noted previously with respect to FIG. 1. In this way, cooling assembly 10 will not approach the critical temperature unless phase change material 38 melts, which will not occur during ordinary operation. By storing excess heat during peak conditions, thermal capacitor 18 obviates the need for extensive cooling apparatus which would be excessive during non-peak operation of electronic component 12. This allows cooling assembly 10 to be lighter and more compact than conventional cooling assemblies.

While the invention has been described with reference to an exemplary embodiment(s), it is intended that the invention not be limited to the particular embodiment(s) disclosed, but that the invention is defined by the appended claims.

## Claims

1. A cooling apparatus comprising:
a thermal spreader (14) comprising a heat-pipe plate or a graphite plate adapted to be in direct thermal contact with an electronic component (12);
a phase change thermal capacitor (18) in thermal contact with the thermal spreader for storing heat in a phase transition during peak thermal loads of the electronic component or conditions of reduced cooling; and
a cold plate (16) in direct thermal contact with the thermal spreader, for dissipating heat from the thermal spreader.

2. The cooling apparatus of claim 1, wherein the phase change thermal capacitor (18) comprises a thermally conductive receptacle (22) filled with a phase change material (38).

3. The cooling apparatus of claim 2, wherein the phase change material (38) comprises paraffin-wax.

4. The cooling apparatus of claim 2 or 3, wherein at least one of the cold plate (16) and the conductive receptacle (22) are formed of aluminum.

5. The cooling apparatus of claim 2, 3 or 4, wherein the phase change thermal capacitor (18) comprises a plurality of separate thermally conductive receptacles (22) filled with the phase change material (38).

6. The cooling apparatus of any preceding claim, wherein the thermal spreader (14) is a graphite plate.

7. The cooling apparatus of any of claims 1 to 5, wherein the thermal spreader (14) is a heat pipe plate; preferably
wherein the heat pipe plate comprises an aluminum structure carrying methanol as a working fluid; or
wherein the heat pipe plate comprises a copper structure carrying water as a working fluid.

8. The cooling apparatus of any preceding claim, wherein the cold plate (16) is a thermally conductive plate with fins to increase surface area, the fins being in thermal contact with a heat sink fluid.

9. A cooling assembly comprising an electronic component (12) and a cooling apparatus as claimed in any preceding claim, the thermal spreader (14) being in thermal contact with the electronic component (12).

10. The cooling assembly of claim 9, wherein the electronic component (12) is a power conversion component.

11. The cooling assembly of claim 9 or 10, wherein the phase change thermal capacitor (18) comprises a thermally conductive receptacle (22) filled with a phase change material (38) and wherein the phase change material melts at a temperature between a steady state operation temperature of the cooling assembly and a limiting temperature at which the electronic component (12) ceases to function, or at which the lifetime of the electronic component begins to rapidly degrade.

12. The cooling assembly of claim 9, 10 or 11, further comprising thermal interface material (32) located between the thermal spreader (14) and the electronic component (12), between the thermal spreader and the cold plate (16), and between the thermal spreader and the thermal capacitor (18) to improve thermal conductivity between elements; preferably
wherein the thermal interface material is thermal grease; or
wherein the thermal interface material is a conductive thermal pad.

13. A method for providing cooling an electronic component (12) experiencing high peak thermal loads relative to non-peak thermal loads, the method comprising:
conducting heat freely between the electronic component, a cold plate (16), and a thermal capacitor (18) via a thermal spreader (14) comprising a heat pipe plate or a graphite plate in direct thermal contact with the electronic component, the cold plate, and the thermal capacitor;
dissipating heat at the cold plate, so that the electronic component, the cold plate, the thermal capacitor, and the thermal spreader remain at a steady temperature during periods of non-peak thermal loads; and
storing excess heat in a phase transition of the thermal capacitor during periods of peak thermal loads.

14. The method of claim 13, wherein the thermal capacitor (18) comprises a thermally conductive receptacle (22) containing a phase change material (38) with a melting temperature between the steady state temperature and a limiting temperature at which the electronic component (12) ceases to function, or at which the lifetime of the electronic component rapidly degrades.

## Patentansprüche

1. Kühlvorrichtung, umfassend:
einen Wärmeverteiler (14), umfassend eine Wärmerohrplatte oder eine Graphitplatte, die dazu ausgebildet ist, in direktem Wärmekontakt mit einer elektronischen Komponente (12) zu stehen;
einen Phasenwechsel-Wärmekondensator (18) in Wärmekontakt mit dem Wärmeverteiler zum Speichern von Wärme in einem Phasenübergang bei Spitzenwärmelasten der elektronischen Komponente oder Bedingungen mit reduzierter Kühlung; und
eine Kaltplatte (16) in direktem Wärmekontakt mit dem Wärmeverteiler, um Wärme vom Wärmeverteiler abzuleiten.

2. Kühlvorrichtung nach Anspruch 1, wobei der Phasenwechsel-Wärmekondensator (18) einen wärmeleitfähigen Behälter (22) umfasst, der mit einem Phasenwechselmaterial (38) gefüllt ist.

3. Kühlvorrichtung nach Anspruch 2, wobei das Phasenwechselmaterial (38) Paraffinwachs umfasst.

4. Kühlvorrichtung nach Anspruch 2 oder 3, wobei wenigstens eins von der Kaltplatte (16) und dem leitfähigen Behälter (22) aus Aluminium gebildet ist.

5. Kühlvorrichtung nach Anspruch 2, 3 oder 4, wobei der Phasenwechsel-Wärmekondensator (18) eine Vielzahl von separaten wärmeleitfähigen Behältern (22) umfasst, die mit dem Phasenwechselmaterial (38) gefüllt sind.

6. Kühlvorrichtung nach einem der vorangehenden Ansprüche, wobei der Wärmeverteiler (14) eine Graphitplatte ist.

7. Kühlvorrichtung nach einem der Ansprüche 1 bis 5, wobei der Wärmeverteiler (14) eine Wärmerohrplatte ist; vorzugsweise
wobei die Wärmerohrplatte eine Aluminiumstruktur umfasst, die Methanol als ein Arbeitsfluid transportiert; oder
wobei die Wärmerohrplatte eine Kupferstruktur umfasst, die Wasser als ein Arbeitsfluid transportiert.

8. Kühlvorrichtung nach einem der vorangehenden Ansprüche, wobei die Kaltplatte (16) eine wärmeleitfähige Platte mit Lamellen zum Vergrößern der Oberfläche ist, wobei die Lamellen in Wärmekontakt mit einem Wärmesenkenfluid stehen.

9. Kühlungsbaugruppe, umfassend eine elektronische Komponente (12) und eine Kühlvorrichtung nach einem der vorangehenden Ansprüche, wobei der Wärmeverteiler (14) in Wärmekontakt mit der elektronischen Komponente (12) steht.

10. Kühlungsbaugruppe nach Anspruch 9, wobei die elektronische Komponente (12) eine Leistungswandlungskomponente ist.

11. Kühlungsbaugruppe nach Anspruch 9 oder 10, wobei der Phasenwechsel-Wärmekondensator (18) einen wärmeleitfähigen Behälter (22) umfasst, der mit einem Phasenwechselmaterial (38) gefüllt ist, und wobei das Phasenwechselmaterial bei einer Temperatur zwischen einer Dauerbetriebstemperatur der Kühlungsbaugruppe und einer Begrenzungstemperatur schmilzt, bei der die elektronische Komponente (12) nicht mehr funktioniert oder bei der die Lebensdauer der elektronischen Komponente rasch abzunehmen beginnt.

12. Kühlungsbaugruppe nach Anspruch 9, 10 oder 11, ferner umfassend ein Wärmegrenzflächenmaterial (32), das zwischen dem Wärmeverteiler (14) und der elektronischen Komponente (12), zwischen dem Wärmeverteiler und der Kaltplatte (16) und zwischen dem Wärmeverteiler dem Wärmekondensator (18) angeordnet ist, um die Wärmeleitfähigkeit zwischen Elementen zu verbessern; vorzugsweise
wobei das Wärmegrenzflächenmaterial eine Wärmeleitpaste ist; oder
wobei das Wärmegrenzflächenmaterial ein wärmeleitfähiger Überzug ist.

13. Verfahren zum Bereitstellen von Kühlung einer elektronischen Komponente (12), die hohen Spitzenwärmelasten im Verhältnis zu Nichtspitzenwärmelasten unterliegt, wobei das Verfahren Folgendes umfasst:
freies Leiten von Wärme zwischen der elektronischen Komponente, einer Kaltplatte (16) und einem Wärmekondensator (18) über einen Wärmeverteiler (14), der eine Wärmerohrplatte oder eine Graphitplatte in direktem Wärmekontakt mit der elektronischen Komponente, der Kaltplatte und dem Wärmekondensator umfasst;
Ableiten von Wärme an der Kaltplatte, sodass die elektronische Komponente, die Kaltplatte, der Wärmekondensator und der Wärmeverteiler in Zeiten von Nichtspitzenwärmelasten bei einer Dauertemperatur bleiben; und
Speichern überschüssiger Wärme in einem Phasenübergang des Wärmekondensators in Zeiten von Spitzenwärmelasten.

14. Verfahren nach Anspruch 13, wobei der Wärmekondensator (18) einen wärmeleitfähigen Behälter (22) umfasst, der ein Phasenwechselmaterial (38) mit einer Schmelztemperatur zwischen der Dauertemperatur und einer Begrenzungstemperatur enthält, bei der die elektronische Komponente (12) nicht mehr funktioniert oder bei der die Lebensdauer der elektronischen Komponente rasch abnimmt.

## Revendications

1. Appareil de refroidissement comprenant :
un dissipateur thermique (14) comprenant une plaque de caloduc ou une plaque en graphite conçue pour être en contact thermique direct avec un composant électronique (12) ;
un condensateur thermique à changement de phase (18) en contact thermique avec le dissipateur thermique pour stocker de la chaleur dans une transition de phase pendant des charges thermiques maximales du composant électronique ou dans des conditions de refroidissement réduit ; et
une plaque froide (16) en contact thermique direct avec le dissipateur thermique, pour dissiper de la chaleur à partir du dissipateur thermique.

2. Appareil de refroidissement selon la revendication 1, dans lequel le condensateur thermique à changement de phase (18) comprend un récipient thermoconducteur (22) rempli avec un matériau à changement de phase (38).

3. Appareil de refroidissement selon la revendication 2, dans lequel le matériau à changement de phase (38) comprend de la cire de paraffine.

4. Appareil de refroidissement selon la revendication 2 ou 3, dans lequel au moins un élément parmi la plaque froide (16) et le récipient conducteur (22) est formé d'aluminium.

5. Appareil de refroidissement selon la revendication 2, 3 ou 4, dans lequel le condensateur thermique à changement de phase (18) comprend une pluralité de récipients thermoconducteurs séparés (22) remplis avec le matériau à changement de phase (38).

6. Appareil de refroidissement selon une quelconque revendication précédente, dans lequel le dissipateur thermique (14) est une plaque en graphite.

7. Appareil de refroidissement selon l'une quelconque des revendications 1 à 5, dans lequel le dissipateur thermique (14) est une plaque de caloduc ; de préférence dans lequel la plaque de caloduc comprend une structure en aluminium transportant du méthanol comme fluide actif ; ou dans lequel la plaque de caloduc comprend une structure en cuivre transportant de l'eau comme fluide actif.

8. Appareil de refroidissement selon une quelconque revendication précédente, dans lequel la plaque froide (16) est une plaque thermoconductrice avec des ailettes pour accroître la surface, les ailettes étant en contact thermique avec un fluide dissipateur de chaleur.

9. Ensemble de refroidissement comprenant un composant électronique (12) et un appareil de refroidissement tel que revendiqué dans une quelconque revendication précédente, le dissipateur thermique (14) étant en contact thermique avec le composant électronique (12).

10. Ensemble de refroidissement selon la revendication 9, dans lequel le composant électronique (12) est un composant de conversion d'énergie.

11. Ensemble de refroidissement selon la revendication 9 ou 10, dans lequel le condensateur thermique à changement de phase (18) comprend un récipient thermoconducteur (22) rempli avec un matériau à changement de phase (38) et dans lequel le matériau à changement de phase fond à une température entre une température de fonctionnement en régime stationnaire de l'ensemble de refroidissement et une température limitante à laquelle le composant électronique (12) cesse de fonctionner, ou à laquelle la durée de vie du composant électronique commence à se dégrader rapidement.

12. Ensemble de refroidissement selon la revendication 9, 10 ou 11, comprenant en outre un matériau d'interface thermique (32) situé entre le dissipateur thermique (14) et le composant électronique (12), entre le dissipateur thermique et la plaque froide (16), et entre le dissipateur thermique et le condensateur thermique (18) pour améliorer la conductivité thermique entre éléments ; de préférence
dans lequel le matériau d'interface thermique est une graisse thermique ; ou
dans lequel le matériau d'interface thermique est une pastille thermoconductrice.

13. Procédé assurant le refroidissement d'un composant électronique (12) subissant des charges thermiques maximales élevées par rapport à des charges thermiques non maximales, le procédé comprenant :
la conduction de chaleur librement entre le composant électronique, une plaque froide (16), et un condensateur thermique (18) par l'intermédiaire d'un dissipateur thermique (14) comprenant une plaque de caloduc ou une plaque en graphite en contact thermique direct avec le composant électronique, la plaque froide, et le condensateur thermique ;
la dissipation de la chaleur au niveau de la plaque froide, de sorte que le composant électronique, la plaque froide, le condensateur thermique, et le dissipateur thermique restent à une température stable pendant des périodes de charges thermiques non maximales ; et
le stockage de la chaleur en excès dans une transition de phase du condensateur thermique pendant des périodes de charges thermiques maximales.

14. Procédé selon la revendication 13, dans lequel le condensateur thermique (18) comprend un récipient thermoconducteur (22) contenant un matériau à changement de phase (38) ayant une température de fusion comprise entre la température en régime stationnaire et une température limitante à laquelle le composant électronique (12) cesse de fonctionner, ou à laquelle la durée de vie du composant électronique se dégrade rapidement.
